# EUROPÄISCHE PATENTSCHRIFT

(11) **EP 1 530 807 B1**
(45) Veröffentlichungstag und Bekanntmachung des Hinweises auf die Patenterteilung: **31.10.2007**
(21) Anmeldenummer: 03792108.7
(22) Anmeldetag: 03.06.2003
(51) Int. Cl.: H01L 41/083

(54) **PIEZOAKTOR**
PIEZO ACTUATOR
ACTIONNEUR PIEZOELECTRIQUE

(30) Priorität: 16.08.2002 DE 10237589
(43) Veröffentlichungstag der Anmeldung: 18.05.2005
(73) Patentinhaber: ROBERT BOSCH GMBH, 70442 Stuttgart (DE)
(72) Erfinder: SUGG, Bertram, 70839 Gerlingen (DE)
(86) Internationale Anmeldenummer: PCT/DE2003/001810
(87) Internationale Veröffentlichungsnummer: WO 2004/019425

(56) Entgegenhaltungen:
- EP-A- 0 603 835
- WO-A-01/91198
- DE-A- 4 107 158
- DE-A- 19 753 930
- DE-A- 19 928 178
- JP-A- 7 154 005

## Beschreibung

### Stand der Technik

Die Erfindung betrifft einen Piezoaktor, beispielsweise zur Betätigung eines mechanischen Bauteils, nach den gattungsgemäßen Merkmalen des Hauptanspruchs.

Es ist allgemein bekannt, dass unter Ausnutzung des sogenannten Piezoeffekts ein Piezoelement aus einem Material mit einer geeigneten Kristallstruktur aufgebaut werden kann. Bei Anlage einer äußeren elektrischen Spannung an diese piezoelektrischen und elektrostriktiven Keramiken erfolgt eine mechanische Reaktion des Piezoelements, die in Abhängigkeit von der Kristallstruktur und der Anlagebereiche der elektrischen Spannung einen Druck oder Zug in eine vorgebbare Richtung darstellt.

Aufgrund des extrem schnellen und genau regelbaren Hubeffektes können solche Piezoaktoren zum Bau von Stellern, beispielsweise für den Antrieb von Schaltventilen bei Kraftstoffeinspritzsystemen in Kraftfahrzeugen vorgesehen werden. Hierbei wird die spannungs- oder ladungsgesteuerte Auslenkung des Piezoaktors zur Positionierung eines Steuerventils genutzt, das wiederum den Hub einer Düsennadel regelt.

Da die erforderlichen elektrischen Feldstärken zur Betätigung des Piezoaktors im Bereich von mehreren kV/mm liegen und in der Regel moderate elektrische Spannungen zur Ansteuerung gewünscht sind, erfolgt der Aufbau dieses Piezoaktors hier in mehreren Schichten von übereinandergestapelten metallisierten Piezokeramiken zu einem sog. Multilayer-Aktor. Hierzu sind jeweils zwischen den Schichten Innenelektroden vorhanden, die z.B. mit einem Druckverfahren aufgebracht werden, und es sind Außenelektroden vorhanden, über die die elektrische Spannung angelegt wird. Ein typisches Verfahren zum Herstellen solcher Schichten besteht in der Foliengießtechnik. Die einzelnen Schichten werden dabei zur Herstellung der Innenelektroden metallisiert und übereinandergestapelt, wobei dann zwischen zwei Schichten mit Innenelektroden unterschiedlicher Polarität sich der Piezoeffekt auswirkt.

Am Kopf- und Fußbereich fehlen jedoch in der Regel die Innenelektroden, da zum einen zu den Stirnflächen hin eine gewisse Isolationstrecke nötig ist um Kurzschlüsse nach außen hin zu vermeiden und zum anderen werden passive Zonen zum elektrischen Anschluss der Außenelektroden genutzt. Auch können passive Bereiche inmitten des Aktors vorhanden sein. Oft besteht jedoch in der Zone zwischen dem Bereich mit Innenelektroden als aktive Zone und dem Bereich ohne Innenelektroden als passive Zone die Gefahr von Rissen. Dieses Phänomen hat eine verminderte Lebensdauer zur Folge und kann zum Totalausfall des Aktors führen.

Für sich gesehen ist aus der DE 100 25 998 A1 bekannt, dass an beiden Enden des Lagen- oder Schichtaufbaus passive, in der Länge veränderbare passive Bereiche angeordnet sind. Eine für die jeweilige Einbausituation fest definierte Gesamtlänge des Piezoaktors wird hier über eine Reduktion der Länge des piezoelektrisch inaktiven Kopf- und/oder Fußstücks realisiert, beispielsweise mit einer Hartbearbeitung durch Schleifen oder ähnliches.

Bei diesem bekannten Piezoaktor können zum einen die passiven Schichten aus dem gleichen Keramikmaterial bestehen wie der aktive Bereich, allerdings mit elektrisch einseitig oder gar nicht kontaktierten Außenelektroden, so dass auch die inaktiven Bereiche mit den Innenelektroden-Metallschichten durchsetzt sind. Andererseits kann der jeweilige inaktive Bereich auch ein vollständiger elektrisch isolierter Metall- oder Keramikblock sein, der beispielsweise auf den piezoelektrisch aktiven Bereich einfach aufgeklebt werden kann.

In der JP 7-154005 wird ein piezokeramischer Aktor in Stapelform offengelegt, bei dem keramische passive Bereiche Silber und Palladium als Zusatzstoffe enthalten.

### Vorteile der Erfindung

Der eingangs beschriebene Piezoaktor ist, wie erwähnt, mit einem Mehrschichtaufbau von Piezolagen und in einem piezoelektrisch aktiven Bereich mit zwischen den Lagen angeordneten Innenelektroden aufgebaut und ist mit einer von Schicht zu Schicht wechselnden Kontaktierung der Innenelektroden, zur Beaufschlagung mit einer elektrischen Spannung, versehen. Es ist weiterhin mindestens ein inaktiver Bereich, z.B. ein Fuß- und/oder Kopfteil, an einem Ende oder auch innerhalb des aktiven Bereichs im Bereich der Gesamteinbaulänge im Lagenaufbau des Piezoaktors vorhanden.

In vorteilhafter Weise ist der durch Anspruch 1 definierte erfindungsgemäße Piezoaktor im mindestens einen inaktiven Bereich ohne Innenelektroden aus einem Material gebildet, dessen mechanische und thermische Eigenschaften den Eigenschaften des aktiven Bereichs einschließlich der Kombination und der

Wechselwirkung des Materials der Piezolagen mit den Innenelektroden entsprechen. Entsprechende mechanische und thermische Eigenschaften der Schichten des inaktiven Bereichs und des aktiven Bereichs sind die Wärmedehnung, die Elastizität und die Schwindung beim Sintern des Mehrschichtaufbaus des Piezoaktors.

Die inaktiven Bereiche und der aktive Bereich sind aus einer gleichen keramischen Grundsubstanz hergestellt, wobei in den inaktiven Bereichen zusätzliche Dotierstoffe eingefügt sind. Hierbei ist die Grundsubstanz Bleizirkonattitanat (PZT) und der Dotierstoff ist Silber. Silber ist hier insofern vorteilhaft, da im aktiven Bereich häufig Silber eingebaut wird und daher die Innenelektroden vorzugsweise aus AgPd aufgebaut sind, so dass bei einer Zudotierung von Silber im passiven Bereich ähnliche Eigenschaften erhalten werden.

Mit der Erfindung kann in vorteilhafter Weise insbesondere die Rissneigung bei piezoelektrischen Stapelaktoren im Übergang von aktiven zu inaktiven Bereichen minimiert werden. Dies erfolgt zunächst primär beim Herstellungsprozess, was unmittelbar die Fehlerrate minimiert. Eine Ursache dieser Rissbildung ist hierbei vor allem, dass beim Sintern des Piezoaktors die Keramik im Bereich mit den Innenelektroden in einem anderem Maße als im Bereich ohne Innelektroden schwindet. Dies ist damit verbunden, dass chemische Elemente der Innenelektrode in die Keramik diffundieren, sie dotieren und damit die Schwindungseigenschaften ändern. Der Schwindungsmissmatch führt dann zu den schädlichen mechanischen Spannungen.

Des weiteren fördert die erfindungsgemäße Anordnung aber auch die Zuverlässigkeit während des Betrieb des Piezoaktors. Beim Betrieb des Aktors dehnt er sich im aktiven Bereich aufgrund des Longitudinaleffekts (d₃₃-Effekt) in Längsrichtung. Gleichzeitig tritt jedoch eine Querkontraktion auf (d₃₁-Effekt). Da im passiven Bereich die Keramik starr bleibt, führt dieser Dehnungsunterschied ebenfalls zu mechanischen Spannungen.

Weiterhin unterscheidet sich der Wärmedehnungskoeffizient zwischen dem aktivem und dem passivem Bereich wegen des Einflusses des Metalls der Innenelektroden im aktiven Bereich, so dass bei Temperaturwechseln ebenfalls mechanische Spannungen auftreten. Somit liegt der Vorteil der Erfindung vor allem darin, dass im Bereich zwischen dem aktivem und inaktivem Bereich die mechanischen Spannungen minimiert werden und alle zuvor erwähnten Ursachen dabei berücksichtigt werden um die Rissbildung zu vermeiden.

### Zeichnung

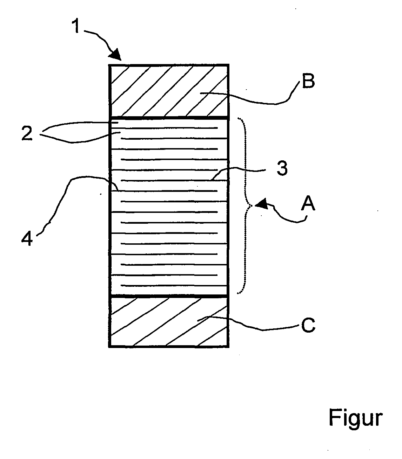

Ein Ausführungsbeispiel des erfindungsgemäßen Piezoaktors wird anhand der einzigen Figur der Zeichnung erläutert, die einen Schnitt durch einen Piezoaktor mit einem Mehrschichtaufbau von Lagen aus Piezokeramik und aktiven und inaktiven Bereichen zeigt.

### Beschreibung der Ausführungsbeispiele

In der Figur ist ein Piezoaktor 1 gezeigt, der in an sich bekannter Weise aus Piezolagen 2 eines Keramikmaterials, z.B. sogenannte Grünfolien, mit einer geeigneten Kristallstruktur aufgebaut ist, so dass unter Ausnutzung des sogenannten Piezoeffekts bei Anlage einer äußeren elektrischen Gleichspannung an Innenelektroden 3 und 4 über hier nicht näher dargestellte außen kontaktierte Elektroden eine mechanische Reaktion des Piezoaktors 1 erfolgt.

Der Piezoaktor 1 ist in einen piezoelektrisch aktiven Bereich A und zwei am Kopf- und am Fußende angebrachte inaktive bzw. passive Bereiche B und C aufgeteilt. Aktiv wird in diesem Zusammenhang ein Bereich bezeichnet, der von den Innelektroden 3 und 4 wechselnder Polarität durchsetzt ist und letztendlich also zu der für den Betrieb gewollten Längsgesamtdehnung des Piezoaktors 1 beiträgt.

Bei dem erfindungsgemäßen Ausführungsbeispiel wird der Multilayer-Piezoaktor 1 in der Art aufgebaut, dass die Materialzusammensetzung der Keramikschichten im aktiven Bereich A und in den passiven Bereichen B und C sich unterscheiden. Der Unterschied ist so gestaltet, dass dann unter Berücksichtigung der Kombination und der Wechselwirkung des Materials der Piezolagen und der Innenelektroden im Bereich A die mechanischen und thermischen Eigenschaften der Schichten des inaktiven Bereichs B, C und des aktiven Bereichs A, insbesondere die Wärmedehnung, die Elastizität und die Schwindung beim Sintern des Mehrschichtaufbaus des Piezoaktors kompatibel sind.

Es sind somit an sich für die Grünfolienherstellungen zwei Keramiksorten notwendig. Dies können zum Beispiel verschieden aufbereitete Keramiksorten sein, z.B. auf einer Basis von Bleizirkonattitanat (PZT). Diese oder andere Keramiken auf einer gemeinsam basierenden Grundsubstanz können durch Hinzufügen geeigneter Dotierstoffe, z. B. Silber, entsprechend verändert und angepasst werden.

Die Keramik des jeweiligen passiven Bereichs B,C wird dabei derart maßgeschneidert, dass die Eigenschaften hinsichtlich einer Schwindung beim Sintern, der Wärmedehnung und der Elastizität in idealer Weise zu der Keramik des aktiven Bereichs A, in Kombination mit den Innenelektroden bzw. der Wechselwirkung daraus, kompatibel ist.

Somit können aus diesen beiden Keramiken zwei Grünfolientypen hergestellt werden, wobei beim Stapeln zum sog. Grünkörper des Piezoaktors 1 dann für den Fuß- und Kopfbereich B und C und eventuellen, hier nicht dargestellten Zwischenbereichen, Folien des Typs für den Bereich B und C verwendet werden. Für den oder die aktiven Bereiche werden Grünfolien für den aktiven Bereich A verwendet, wobei diese Grün- oder Keramikfolien dann nur noch zur Herstellung der Innenelektroden metallisiert werden müssen.

## Patentansprüche

1. Piezoaktor, mit
- einem Mehrschichtaufbau von Piezolagen (2) und in einem piezoelektrisch aktiven Bereich (A) zwischen den Lagen angeordneten Innenelektroden (3, 4), die mit einer elektrischen Spannung beaufschlagbar sind und mit
- mindestens einem inaktiven Bereich (B, C) ohne Innenelektroden im Lagenaufbau des Piezoaktors (1),
- wobei der mindestens eine inaktive Bereich (B, C) ohne Innenelektroden aus einem Material gebildet ist, dessen mechanische und thermische Eigenschaften der Schwindung beim Sintern des Mehrschichtaufbaus des Piezoaktors (1) den Eigenschaften des aktiven Bereichs (A) einschließlich der Kombination und der Wechselwirkung des Materials der Piezolagen (2) und der Innenelektroden (3, 4) entsprechen,
**dadurch gekennzeichnet, dass**
- zusätzlich die mechanischen und thermischen Eigenschaften
- der Wärmedehnung und
- der Elastizität
des Materials des mindestens einen inaktiven Bereichs (B, C) ohne Innenelektroden den Eigenschaften des aktiven Bereichs (A) einschließlich der Kombination und der Wechselwirkung des Materials der Piezolagen (2) und der Innenelektroden (3, 4) entsprechen,
- wobei die inaktiven Bereiche (B, C) und der aktive Bereich (A) aus der keramischen Grundsubstanz Bleizirkonattitanat-(PZT) hergestellt und die inaktiven Bereiche (B, C) zusätzlich mit Silber dotiert sind.

## Claims

1. Piezoactuator, with
- a multi-layer construction of piezolayers (2) and of inner electrodes (3, 4) which are arranged in a piezoelectrically active region (A) between the layers and which can be acted upon by an electrical voltage, and with
- at least one inactive region (B, C) without inner electrodes in the layered construction of the piezoactuator (1),
- the at least one inactive region (B, C) without inner electrodes being formed from a material, of which the mechanical and thermal contraction properties during the sintering of the multi-layer construction of the piezoactuator (1) correspond to the properties of the active region (A), including the combination and interaction of the material of the piezolayers (2) and of the inner electrodes (3, 4),
**characterized in that**,
- additionally, the mechanical and thermal properties
- of thermal expansion and
- of elasticity
of the material of the at least one inactive region (B, C) without inner electrodes correspond to the properties of the active region (A), including the combination and the interaction of the material of the piezolayers (2) and of the inner electrodes (3, 4),
- the inactive regions (B, C) and the active region (A) being produced from the basic ceramic substance, lead zirconate titanate (PZT), and the inactive regions (B, C) being additionally doped with silver.

## Revendications

1. Actionneur piézo-électrique comportant :
- des couches piézo-électriques (2) en structure multicouches et des électrodes intérieures (3, 4) installées entre les couches dans la zone piézo-électrique active (A), ces électrodes recevant une tension électrique ; et
- au moins une zone inactive (B, C) sans électrodes internes dans la structure en couches de l'actionneur piézo-électrique (1),
- au moins cette zone inactive (B, C) sans électrodes internes étant réalisée en un matériau dont les propriétés mécaniques et thermiques correspondent à la disparition, lors du frittage de la structure multicouches de l'actionneur piézo-électrique (1), des propriétés de la zone active (A) y compris de la combinaison et de l'interaction de la matière des couches piézo-électriques (2) et des électrodes internes (3, 4),
**caractérisé en ce que**
- en plus, les propriétés mécaniques et thermiques ;
- la dilatation thermique ; et
- l'élasticité de la matière au moins de cette zone inactive (B, C) sans électrodes intérieures correspondent aux propriétés de la zone active (A) y compris de la combinaison de l'interaction de la matière des couches piézo-électriques (2) et des électrodes internes (3, 4),
- les zones inactives (B, C) et la zone active (A) étant fabriquées en une substance de base céramique de zirconate-titanate de plomb (PZT) et les zones inactives (B, C) sont dopées en plus avec de l'argent.
